# EUROPEAN PATENT APPLICATION

(11) **EP 1 333 470 A1**
(43) Date of publication of application: **06.08.2003**
(21) Application number: 02002282.8
(22) Date of filing: 30.01.2002
(51) Int. Cl.: H01L 21/02, H01L 21/8242, H01L 21/334

(54) **Integrated capacitor having a silicon electrode and a method of forming the capacitor**

(71) Applicant: Infineon Technologies AG, 81669 München (DE)
(72) Inventor: Veloso, Anabela, 3001 Leuven (BE); Cappellani, Annalisa, 96100 Siracusa (IT)
(74) Representative: Epping Hermann & Fischer

(57) **Abstract**

The present invention is related to a capacitor which can be part of a memory device and the method of fabricating it. The capacitor has at least one electrode (10) consisting of silicon. A chemical vapor deposition process comprising a composition of gases comprising germanium generates an epitaxial layer of Silicon-Germanium or germanium. The epitaxial layer breaks into islands (30) of germanium or Silicon-Germanium depending on the process parameters. The active surface of the capacitor electrode (10) as well as the capacity is increased.

## Description

Integrated capacitor having a silicon electrode and a method of forming the capacitor

The present invention relates to a capacitor having at least one electrode comprising silicon and a method of manufacturing it in order to increase its capacity.

Memory devices, such as dynamic random access memories, comprise a capacitor to store information by means of storing a charge. In every new generation of memory devices the size of the memory cells and also the size of the capacitors decrease. The specific capacity of the capacitors is wished to increase. In general, there are three possibilities to increase the capacity:
- Reducing the distance between the electrodes of the capacitor and, with that, reducing the thickness of the dielectric material. This method is limited by increasing of leakage current due to direct tunnelling;
- Using materials with high dielectric constant (high k) dielectric material with the problem of thermodynamic instability at high temperatures, at the present premature stage of study of these materials;
- Increasing the surface area of the active electrode of the capacitor by roughening the surface or by forming hemispherical grains of silicon on the surface of the electrode.

In JP 2000-216346 A a capacitor with hemispherical grains on the surface of at least one electrode and a method of forming it is disclosed. In this capacitor the lower electrode is formed of amorphous silicon layers comprising at least two parts of different doping concentrations. The smaller hemispherical grains are formed on the part of the electrode with the higher doping concentration, the larger grains are formed on the electrode having the lower doping concentration.

In US 6,150,208 a method of forming a DRAM capacitor is described where at least one electrode is formed of a Silicon-Germanium alloy. The Silicon-Germanium alloy has a rough surface morphology and can be formed by conventional depositing techniques including Low Pressure Chemical Vapor Deposition or Plasma Enhanced Chemical Vapor Deposition (LPCVD and PECVD).

Generally, hemispherical grains (HSG) consist of silicon, since the electrode is made of silicon. The process of forming hemispherical grains may be carried out selectively or non-selectively. In the non-selective process (after the growth of a thin chemical oxide on the silicon surface of the electrode), a thin amorphous silicon film is deposited. Subsequently, the hemispherical grains are formed (in the whole electrode surface) and posteriorely removed from a region that should remain insulated. In the selective method, the hemispherical grains are grown only on the silicon surface and not on any nitride or oxide area. In particular, the silicon surface of the electrode is cleaned and a thin SiO2 layer is formed. Then an amorphous silicon layer is grown and partially removed from the region that should remain insulated and from the wafer surface. Subsequently a thermal step in a highly diluted SiH4 in N2 (about 1:100) ambient is used to generate randomly seeds on the amorphous silicon surface. In the following step, a N2 only anneal will enhance silicon surface mobility so that at the seed location the silicon atoms will cluster forming hemispheres. The selective process is preferred because it does not require the etching of the hemispherical grains out of the region where hemispherical grains should not be.

However, the controlling of grain uniformity, grain location, density and size during this process (selective or non selective) is not possible.

In F.M.Ross: "Dynamics Studies of Semiconductor Growth Processes Using In Situ Electron Microscopy" the growth of "Quantum Dots" is described. The "Quantum Dots" are volumes of material so small that their electronic properties differ from the properties of the bulk material. The creation of these "Quantum Dots" starts with the growing of an epitaxial layer of germanium or Silicon-Germanium on a silicon surface of an electrode during a chemical vapor deposition process. This epitaxial layer will cause strain energy to build up onto the silicon surface due to the different lattice parameters of the different materials. The strain energy increases according to the increasing of the Silicon-Germanium or germanium epitaxial layer thickness. The system relieves this strain energy by clustering together and forming islands of Silicon-Germanium or germanium. The islands grow in rows at locations where a slip plane intersects the surface of the epitaxial layer coming from the maximum of the strain energy in the silicon layer with an angle of approximately 60° relative to the surface of the epitaxial layer. According to the explanation of the document, at the expense of some extra surface energy, material at the top of the islands is able to relax towards its bulk lattice parameter as it is further away from the constraining substrate. The size and the density of these islands depend on the thickness of the epitaxial layer. At a defined thickness, the forming of islands starts. As more germanium is supplied onto the surface, the smaller higher-energy islands disappear and the larger lower-energy islands increase.

The object of the present invention is to provide another possibility to enhance the capacity of the capacitor and a method to fabricate the capacitor.

The solution according to the invention is a capacitor according to the features of claim 1.

On the surface of the silicon electrode islands of Silicon-Germanium or Germanium are grown up. This is true for trench capacitors as well as for stacked capacitors according to claims 3 and 4, respectively. The capacitors can be used in dynamic random access memory devices but they are not restricted to such devices.

Also a method of forming such islands is claimed in claims 5 to 10. In a single chemical vapor deposition (CVD) step, using a composition of gases comprising Ge2H6 and He or Ge2H6, He and Si2H6, a layer of germanium or Silicon-Germanium is epitaxially grown on the surface of the electrode comprising silicon. During this process the epitaxial layer breaks. The broken parts of the epitaxial layer cluster together and form islands of germanium or Silicon-Germanium. The process works under the conditions of low pressure (10⁻⁵ Torr - 10⁻⁷ Torr) at temperatures of about 600°C to 750°C. Applying an atmosphere which comprises Ge2H6, He and Si2H6, Silicon-Germanium islands will be created. Applying an atmosphere comprising Ge2H6 and He, germanium islands will be created. Also, depending on the amount of germanium used in the process atmosphere, the thickness of the epitaxial layer is controlled. After the beginning of forming islands, the density and the size of the islands are independently controllable. With an additional amount of germanium the smaller islands disappear, the larger islands increase and the density decreases. With increasing deposition time, the diameter of the islands increases, with Ge atoms leaving the smaller, higher-energy islands, diffusing along the surface, and impinging on the larger, lower-energy islands. By creating islands of germanium or Silicon-Germanium the surface of one of the electrodes of a capacitor is increased. Hence the capacity of the capacitor is increased.

It is of advantage that this enhancement of the capacity can be used for stacked or trench capacitors having at least one electrode comprising silicon.

It is a favourable aspect of the invention to obtain Silicon-Germanium islands. Since the strain energy the epitaxial layer of Silicon-Germanium alloy causes onto the surface of silicon is lower than the strain energy of germanium onto the surface of silicon, all growth phenomena take place at larger volumes.

It is also advantageous to grow germanium islands to achieve smaller islands at a higher density.

Furthermore it is advantageous to form the islands by a single step during the chemical vapor deposition process.

The invention is described by means of the following figures. Although the figures represent only two embodiments of the invention, other embodiments are also possible.
- Figure 1: shows a trench in a substrate with an insulation collar and a first electrode made of silicon;
- Figure 2: shows a trench with an insulation collar and a first electrode made of silicon and an epitaxial layer;
- Figure 3: shows a trench with an insulation collar and a first electrode made of silicon with islands consisting of Silicon-Germanium or germanium on the surface of the electrode;
- Figure 4: shows a trench capacitor with islands consisting of Silicon-Germanium or germanium on the surface of the first electrode with a second electrode and a dielectric layer between the two electrodes;
- Figure 5: shows the principle of the growth of islands consisting of germanium or Silicon-Germanium on a germanium layer or on a Silicon-Germanium alloy layer located on a silicon substrate; and
- Figure 6: shows a stacked capacitor with islands consisting of germanium or Silicon-Germanium on both electrodes and a dielectric layer between the two electrodes.

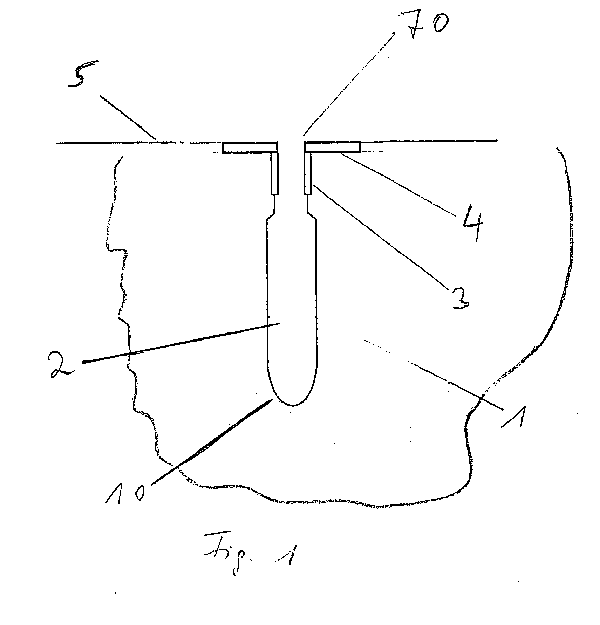

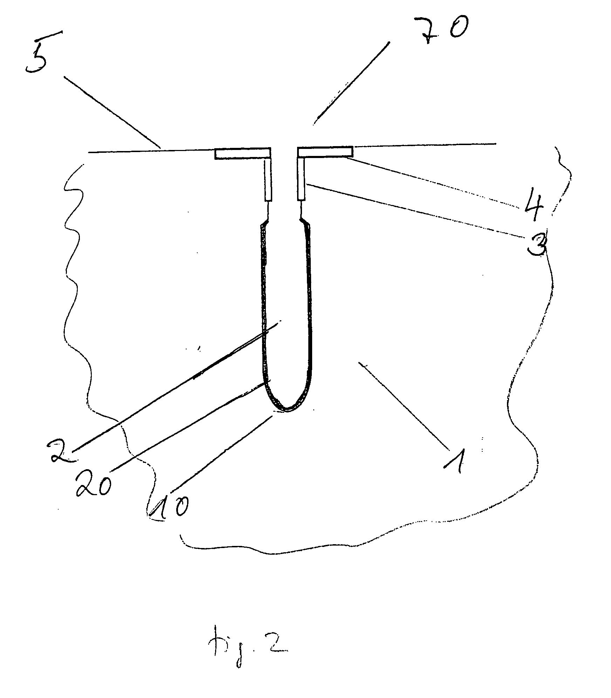

Figure 1 shows a trench 2 of a trench capacitor in a substrate 1. The trench 2 is formed during a process comprising the following steps: On the surface of the substrate 1 an isolation layer is formed. The isolation layer is structured by a mask layer. By means of the structured isolation layer, the trench 2 is etched into the substrate 1. Subsequently, the collar 3 is formed isolating the upper part of the trench from the side walls of the trench by means of an isolating layer. The isolation collar 3 may be formed in different ways. At least it must be formed before the chemical vapor deposition process starts. The isolation collar 3 isolates the electrode 10 from the surface of the substrate in the upper part of the trench. The collar 3 is made of an insulating material such as SiO2. Here the function of the collar 3 is to protect the upper region of the trench from being attacked at the same time as the silicon of the electrode by the gases used in the CVD process. After forming the isolation collar 3, the surface 5 of the substrate 1 is planarized and next steps like forming gate electrodes for a transistor or a memory cell may follow. On the inner surface of the trench 2, in the lower part of the trench 2, a first electrode 10 is formed by depositing a thin film of amorphous silicon (electrode 10) on the trench 2 (after cleaning the silicon surface of the electrode and growing a thin oxide layer like SiO2 on it) and then partially removing it from the collar region 3 of the trench 2 and from the surface 5. The electrode 10 comprises therefore silicon. An insulation layer 4 isolates the upper part of the trench. The first electrode 10, which is part of the trench 2, will be the basis for the next figure 2. Although described in conjunction with a trench capacitor the following steps to form a capacitor can be executed on every electrode comprising silicon.

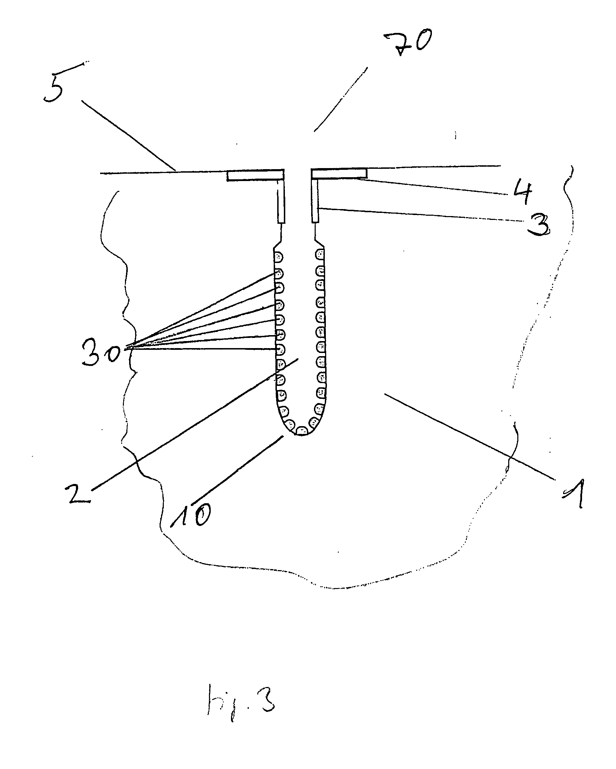

Figure 2 shows the trench 2 with the insulation collar 3 of a trench capacitor 70 having an epitaxial layer 20 comprising germanium or Silicon-Germanium alloy on the first electrode 10. This epitaxial layer 20 is grown during a chemical vapor deposition process using a composition of gases comprising at least Ge2H6 and He at a specific ratio, specific temperature and specific low pressure depending on what kind of islands is wished to be produced. Due to the different lattice parameters of silicon, germanium and Silicon-Germanium alloy, the epitaxial layer 20 causes strain on the silicon surface of the electrode. The strain energy increases with the increasing of the epitaxial layer 20 thickness. With an additional strain onto the silicon surface, which means an additional amount of germanium or Silicon-Germanium onto the epitaxial layer 20, the epitaxial layer 20 breaks while forming islands, which is described in figure 3. The chemical vapor deposition process takes place at temperatures between 600°C and 750°C, pressure of about 10⁻⁵ to 10⁻⁷ Torr depending on what kind of islands is wished. The CVD process is selective to some insulation materials such as SiO2 or Si3N4 and no epitaxial layer 20 is in the collar region.

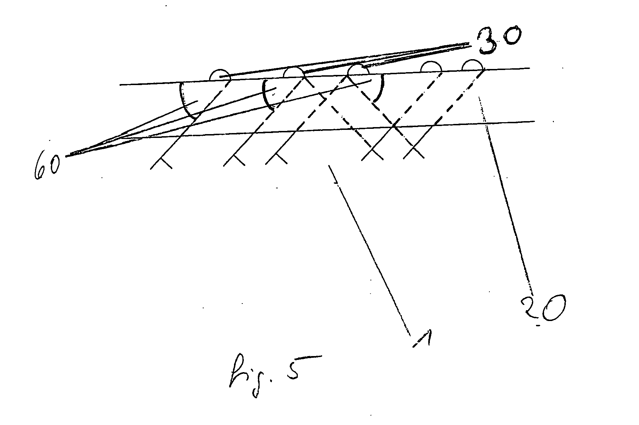

The situation after the epitaxial layer 20 is broken is shown in Figure 3. The same trench 2 with insulation collar 3 of a trench capacitor is shown. The chemical vapor deposition process has taken place in a reactor where the possibility of controlling the process parameters is given. The epitaxial layer 20 is broken. After the deposition of 2-3 monolayers of SiGe or Ge epitaxial layer 20 is formed, and as growth continues, surface fluctuations followed by nucleation occur, leading to island formation. The surface energy of the islands is smaller than the one of the epitaxial layer 20. By forming into an island parts of the surface of the island are further away from the maximum of the strain which is on the interface of the silicon layer and the Silicon-Germanium or germanium epitaxial layer. (A principle of this process is shown in figure 5). An additional amount of process gases will cause the small islands to disappear and the larger ones to increase. It is preferred to use the composition of Ge2H6/He/Si2H6 at a ratio of 1 for Ge2H6 to 10 for He to 100 for Si2H6, to form Silicon-Germanium islands because their strain energy is lower, so that all growth phenomena take place at larger volumes. This process is carried out at a temperature of about 710°C and a pressure of about 10⁻⁵ Torr. To create germanium islands the process is carried out from a Ge2H6/He atmosphere at a temperature of about 640°C and a pressure of about 10⁻⁷ Torr. The chemical vapor deposition process is selective both to SiO2 and Si3N4. Therefore the insulation collar region is free of islands. The dimension of the islands depends on the amount of germanium and the deposition time. The longer the epitaxial layer 20 is in the process atmosphere and the more Ge2H6 or Ge2H6/Si2H6 is supplied to the surface of the epitaxial layer 20, the larger the islands will be. Also, the islands are more regular than at a shorter deposition time because of the disappearing of the smaller islands. In addition, the density of the islands depends on the growing of the epitaxial layer 20. The density is smaller when the diameter of the islands will grow larger. Therefore the density and the size of the islands are independently controllable.

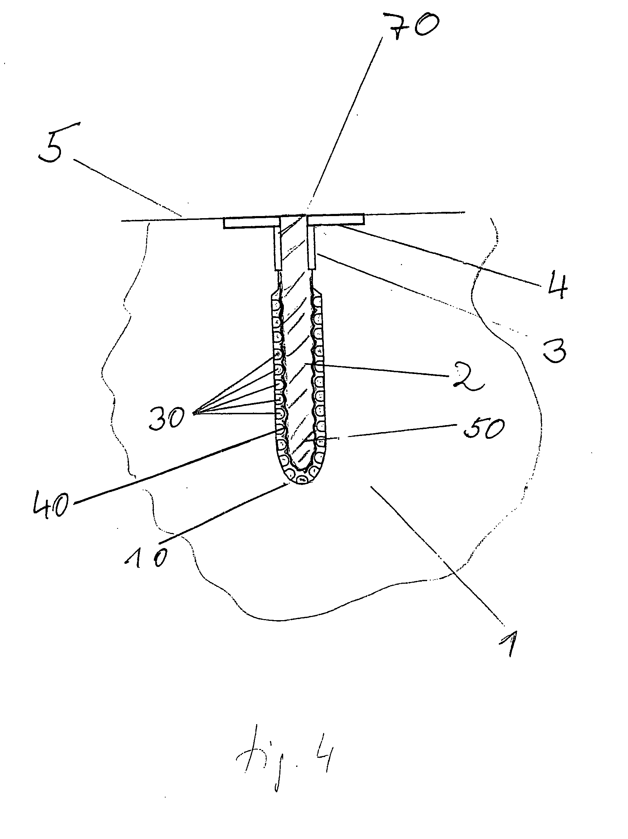

The accomplished trench capacitor 70 is shown in Figure 4. The trench 2, with the insulation collar 3, with a first electrode 10 comprising silicon with islands 30 comprising Silicon-Germanium or germanium on the surface, with a dielectric layer 40 and a second electrode 50. The creation of the islands leads to an enhancement of the surface of the first electrode of about 10% to 80% which means an enhancement of the capacity at the same size. This capacitor is part of a dynamic random access memory cell which is able to store charge in the form of "0"s and "1"s and, with that, information. But the capacitor is not limited for use in DRAM cells.

Figure 5 shows the principle of the growth of islands on the epitaxial layer 20 which comprises a germanium or Silicon-Germanium alloy on a silicon substrate 1. In the substrate 1, it is shown schematically the strain that comes from the mismatched lattice parameters of the different materials. The epitaxial layer 20 is broken. It has partially relaxed, forming misfit dislocations at the layer 20/silicon interface, leading to the formation of islands. The islands are formed at distinct positions which are not exactly above the maximum of strain but dislocated in parallel to the surface of the epitaxial layer 20. The distance of the dislocation corresponds to an angle of about 60° which forms a slip plane coming from the maximum of strain in the substrate 1 with the surface of the epitaxial layer 20. The islands grow in rows associated with these dislocations, in particular at the junction of dislocation pairs.

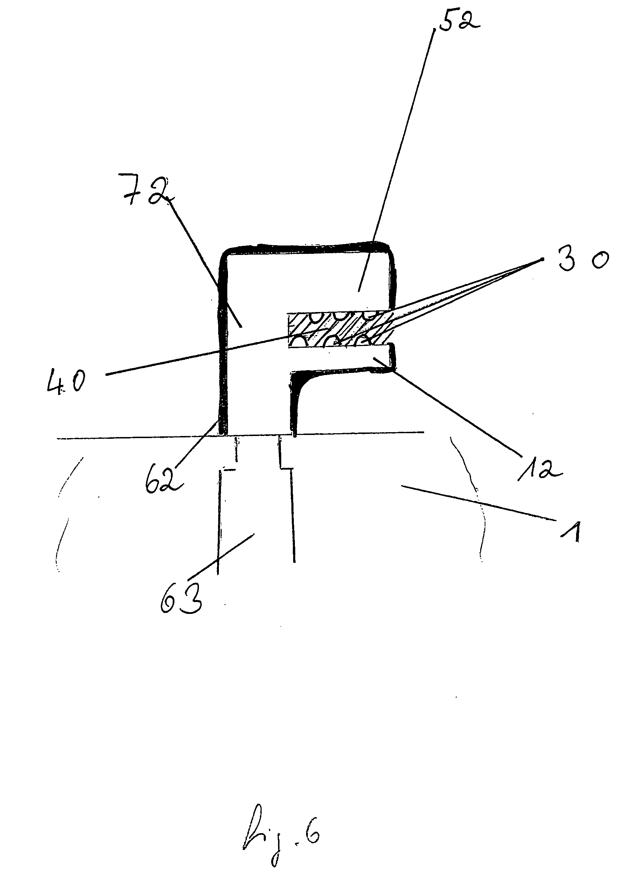

Figure 6 shows a stacked capacitor 72 on a substrate 1. The capacitor is located above the substrate 1 and contacted with a plug 63. The conductive plug 63 is situated in the substrate 1 and enclosed from the substrate 1. The capacitor 72 can be formed by a number of different doped layers of silicon. The different doping allows a selective etching of the different layers. The capacitor 72 comprises a first electrode 12 comprising silicon, a second electrode 52, islands 30 comprising germanium or Silicon-Germanium on at least one of the surfaces of the electrodes 12 and 52 and a dielectric layer 40 between the two electrodes. The capacitor 72 has an isolating layer 62 comprising SiO2 or Si3N4 around the structure 72 which is not electrode 12 or 52. Otherwise, the islands will grow also on the other surfaces.
- 1: Substrate
- 2: Trench
- 3: Isolation collar
- 4: Isolation part on the substrate
- 5: Surface of the substrate

- 10: First electrode of trench capacitor
- 12: First electrode stacked capacitor
- 20: Epitaxial layer
- 30: Islands consisting of Silicon-Germanium or Germanium
- 40: Dielectric layer
- 50: Second Electrode of trench capacitor
- 52: Second Electrode of stacked capacitor
- 60: 60° angle
- 62: Isolation layer
- 63: Plug
- 70: Trench capacitor
- 72: Stacked capacitor

## Claims

1. An integrated capacitor, comprising
a substrate (1) comprising silicon;
a first electrode (10, 12) being arranged relatively to the substrate (1) comprising silicon;
a dielectric layer (40) being arranged on said electrode; a second electrode (50, 52);
islands (30) comprising at least germanium arranged on a surface of said first electrode (10, 12).

2. The capacitor as claimed in claim 1
having islands (30) of Silicon-Germanium alloy arranged on the surface of the silicon electrode (10, 12).

3. The capacitor as claimed in claim 1 or 2, wherein
said substrate (1) comprises a trench (2) having an upper portion and a lower portion;
an insulation collar (3) being provided in the upper portion of the trench (2);
said first electrode (10) being formed in the lower portion of the trench (2);
the second electrode (50);
the dielectric layer (40) between the two electrodes (10, 50).

4. The capacitor as claimed in claim 1 or 2, wherein
said first electrode (12) and said second electrode (52) are arranged above a surface of said substrate (1), and
a dielectric layer (40) is arranged between the two electrodes (12, 52).

5. A method of manufacturing a capacitor as claimed in one of the claims 1 to 4, comprising the steps of:
providing a substrate (1) comprising silicon;
forming one electrode (10, 12) comprising silicon arranged relatively to said substrate (1);
then performing a chemical vapor deposition process on a surface of the first electrode (10, 12) having an atmosphere comprising at least germanium to get islands comprising germanium;
forming a dielectric layer (40) on said first electrode (10, 12);
forming a second electrode (50, 52).

6. The method as claimed in 5 wherein
the atmosphere comprises a composition of gases comprising silicon in the chemical vapor deposition process.

7. The method as claimed in claim 5 or 6 wherein
a composition of Ge2H6 and He and Si2H6 is introduced into a reactor to perform a chemical vapor deposition process, at a ratio of about 1:10:100 for Ge2H6:He:Si2H6,
at a pressure of about 0,5^{·}10⁻⁴ to 0,5^{·}10⁻⁵ Torr, preferably approximately 10⁻⁵ Torr,
at a temperature between 650°C and 750°C, preferably about 710°C.

8. The method as claimed in claim 5 or 6 wherein
an atmosphere of Ge2H6 and He is used in the chemical vapor deposition process,
at a pressure of about 0,5^{·}10⁻⁶ to 0,5^{·}10⁻⁷ Torr, preferably about 10⁻⁷ Torr,
at a temperature between 600°C and 700°C, preferably about 640°C.

9. The method as claimed in one of the claims 5 to 8, comprising the steps of:
forming the trench (2) for a trench capacitor in the substrate (1);
forming an insulation collar (3);
forming the first electrode (10), comprising silicon, in a lower part of said trench (2);
then performing a chemical vapor deposition process to create an epitaxial layer (20) comprising germanium; forming the dielectric layer (40) on said first electrode (10);
forming the second electrode (50) within the trench.

10. The method as claimed in one of the claims 5 to 8, comprising the steps of:
forming the first electrode (12) above the surface of the substrate (1);
applying a chemical vapor deposition process onto the surface of the electrode (12);
covering the electrode with a dielectric layer (40); forming the second electrode (52) to cover the dielectric layer (40).
